Europäisches Patentamt

European Patent Office

Office européen des brevets

(11) Veröffentlichungsnummer: **0 234 288**
**B1**

# EUROPÄISCHE PATENTSCHRIFT

(45) Veröffentlichungstag der Patentschrift:
07.02.90

(51) Int. Cl.⁵: **B 60 R 21/32**

(21) Anmeldenummer: **87100903.1**

(22) Anmeldetag: **23.01.87**

(54) Prüfverfahren für Airbag-System-Auslöseschaltungen.

(30) Priorität: **28.02.86 DE 3606567**

(43) Veröffentlichungstag der Anmeldung:
**02.09.87 Patentblatt 87/36**

(45) Bekanntmachung des Hinweises auf die Patenterteilung:
**07.02.90 Patentblatt 90/06**

(84) Bennante Vertragsstaaten:
**DE ES FR GB IT SE**

(56) Entgegenhaltungen:
**EP-A-0 011 680**
**DE-A-2 808 872**
**DE-B-2 222 038**

(73) Patentinhaber: **AUDI AG**
**Auto-Union-Strasse 1 Postfach 220**
**D-8070 Ingolstadt (DE)**

(72) Erfinder: **Sterler, Georg, Dipl.-Ing.**
**Mozartstrasse 20**
**D-8071 Grossmehring (DE)**
Erfinder: **Bader, Heinz, Dipl.-Ing. (FH)**
**Adrian-von-Ried-Strasse 13**
**D-8859 Karlshuld (DE)**

(74) Vertreter: **Le Vrang, Klaus**
**AUDI AG Postfach 220 Patentabteilung I/EQP**
**D-8070 Ingolstadt (DE)**

LIBERGRAF, STOCKHOLM 1990

**Beschreibung**

Die Erfindung betrifft ein Verfahren zum Prüfen der Auslöseschaltung für ein Airbag-System gemäß dem Oberbegriff des Anspruches 1.

Eine derartige Prüfschaltung und ein Prüfverfahren ist aus der DE-AS-2 222 038 bekannt. Bei diesem bekannten System werden der Auslöseschaltung Prüfimpulse zugeführt, die die einzelnen Komponenten auf ihre Funktionsfähigkeit hin austesten.

Aus der EP-A-0 011 680 ist eine Prüfschaltung für die Auslöseeinrichtung eines Airbags bekannt, die durch ein Prüfprogramm ein auslösendes Signal mit einem einzigen Impuls simuliert. Bei diesem bekannten System wurde überprüft, ob der Impuls die Auslöseeinrichtung ansprechen läßt. Nicht erfaßt wird dabei allerdings ein zu empfindliches System, nämlich einer Auswerteelektronik, die bereits bei geringen Signalen des Beschleunigungsaufnehmers den Airbag zündet. Diese bekannte Einrichtung erkennt somit nur ein nicht funktionierendes, nicht jedoch ein überempfindliches System.

Aufgabe der Erfindung ist es, bei reduziertem Prüfaufwand eine zuverlässige Aussage über die Lage der Einsprechschwelle zu erhalten.

Die Aufgabe wird gelöst durch den Hauptanspruch.

Erfindungsgemäß ist vorgesehen, daß nur ein einziger Prüfimpuls verwendet wird. Mit Hilfe dieses Prüfimpulses können die einzelnen Parameter der Schaltung auf ihre Funktionsfähigkeit hin untersucht werden, insbesondere wird überprüft, ob das Auslösesignal aufgrund des Prüfpulses zu einem vorbestimmten Zeitpunkt auftritt, von dem es bei zu geringer oder zu hoher Ansprechempfindlichkeit abweichen würde.

Bevorzugte Ausführungsformen des erfindungsgemäßen Prüfverfahrens ergeben sich aus den Unteransprüchen.

Im folgenden wird die Erfindung anhand der Zeichnung im Detail beschrieben. Es zeigen:

Fig. 1 eine Prinzipskizze des zu prüfenden Systems;
Fig. 2 den zeitlichen Verlauf einer ersten Ausgestaltung des Prüfimpulses;
Fig. 2b das Integral des Impulses nach Fig. 2a;
Fig. 3a eine zweite Ausgestaltung des zeitlichen Verlaufes des Prüfimpulses;
Fig. 3b das zugehörige Integral, das hinter dem Integrator abgenommen wird;
Fig. 4a eine dritte Ausgestaltung des zeitlichen Verlaufes des Prüfimpulses; und
Fig. 4b das hinter dem Integrator abgenommene Signal.

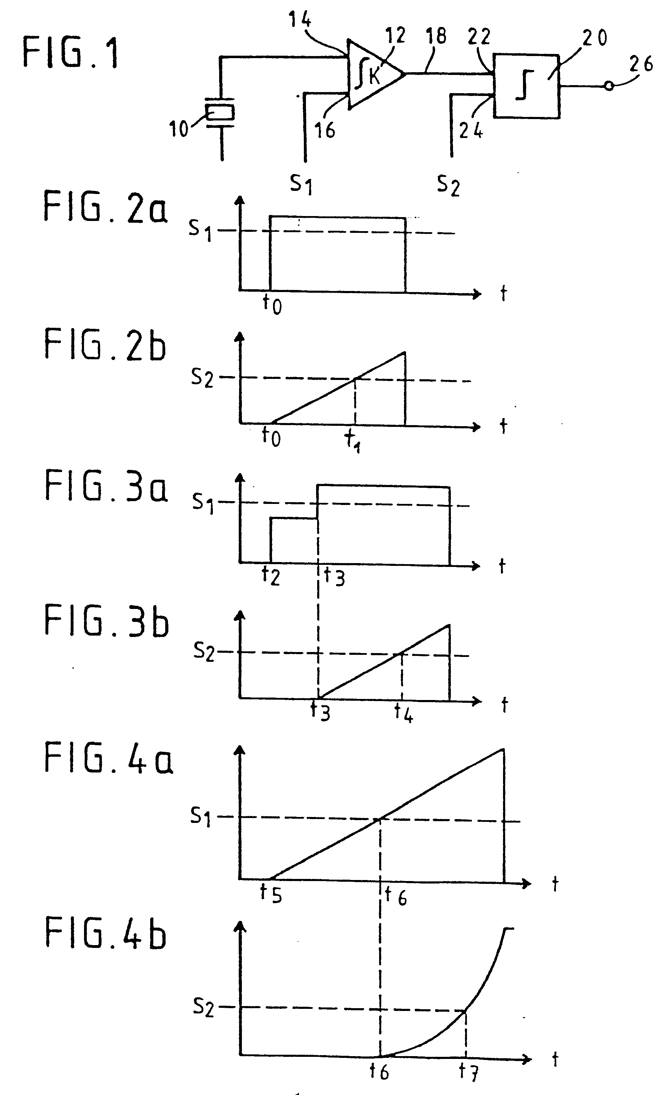

Fig. 1 zeigt den Aufbau einer Prüfschaltung, ein Beschleunigungsaufnehmer 10 gibt bei starken Beschleunigungen oder Verzögerungen ein Signal ab, das einem Integrator 12 über einen ersten Eingang 14 zugeführt wird.

Ein Schwellwert S 1 wird einem zweiten Eingang 16 zugeführt, und sobald der Wert am Eingang 14 über dem Schwellwert liegt, der am Eingang 16 anliegt, beginnt der Integrator 12 mit einer Integrationskonstante k zu integrieren. Das am Ausgang abgenommene Integrationssignal 18 wird dem ersten Eingang 22 eines Schwellwertschalters 20 zugeführt, an dessen zweiten Eingang 24 ein Schwellwert S2 anliegt. Überschreitet das am Eingang 22 auftreffende Signal den Schwellwert S2, schaltet der Schwellwertschalter 20 durch und gibt am Ausgang 26 ein Signal ab.

Für ein Auslösesystem für einen Airbag in einem Kraftfahrzeug dient das Ausgangssignal am Ausgang 26 dazu, den Airbag auszulösen.

Für die Betriebssicherheit ist wünschenswert, daß in regelmäßigen Abständen die Funktionssicherheit dieses System überprüft wird.

Dies geschieht erfindungsgemäß dadurch, daß anstelle des vom Beschleunigungsaufnehmer 10 gelieferten Signals ein Prüfimpuls auf den Eingang 14 gegeben wird, nach dem man den Ausgang 26 der Schaltung von der Auslöseeinrichtung für den Airbag abgekoppelt hat. Führt das Prüfsignal am Eingang 14 dazu, daß am Ausgang 26 das erwartete Signal ansteht, ist die Funktionsfähigkeit der Schaltung nachgewiesen, und der Ausgang 26 wird wieder mit der Auslöseeinrichtung des Airbags verbunden.

Eine erste Form des Prüfimpulses ist in Fig. 2a dargestellt, es handelt sich in diesem Fall um einen Rechteckimpuls, der zu einem Zeitpunkt t0 auf den Eingang 14 des Integrators 12 gelegt wird. Der Rechteckimpuls ist in seiner Amplitude höher als die Schwelle S1, so daß der Integrator 12 sofort aufintegriert, und am Ausgang 18 des Integrators 12 erscheint ständig ansteigend eine Art Sägezahnspannung, die zu einem Zeitpunkt t1 den Schwellwert S2 übersteigt und damit den Schwellwertschalter 20 durchschaltet.

Die Schaltung wird also als funktionsfähig befunden, wenn das Anliegen des Prüfimpulses nach Fig. 2a nach einem Zeitraum t1 - t0 zu einem Signal am Ausgang 26 führt.

Um die richtige Lage des Schwellwertes S1 zu überprüfen, ist eine zweite Impulsform möglich, die in Fig. 3a dargestellt wird. Ein Rechteckimpuls wird zu einem Zeitpunkt t2 gestartet, die Amplitude wird zu einem Zeitpunkt t3 stufenförmig erhöht. Im Zeitraum t3 - t2 ist die Amplitude des Impulses niedriger als der Soll-Schwellwert S1, zum Zeitpunkt t3 jedoch überschreitet die Amplitude den Schwellwert S1. Damit darf der Integrator 12 bei Funktionsfähigkeit erst mit dem Zeitpunkt t3 zu integrieren anfangen und erreicht somit zum Zeitpunkt t4 eine Ausgangsspannung, die den Schwellwert S2 überschreitet, so daß der Schwellwertschalter 20 durchschaltet und es zu einem Signal am Ausgang 26 kommt.

Eine weitere Möglichkeit für den Prüfimpuls ist in Fig. 4a dargestellt, zu einem Zeitpunkt t5 startet eine sägezahnförmige Spannung, die zum Zeitpunkt t6 den Schwellwert S1 überschreitet, so daß der Integrator 12 mit dem Integrationsvorgang beginnt.

Die Integrationsspannung und somit das Ausgangssignal des Integrators 12 ist in Fig. 4b dargestellt, zum Zeitpunkt t7 erreicht die Ausgangsspannung einen den Schwellwert S2 übersteigenden Wert, so daß der Schwellwertschalter 20 durchschaltet.

Bei den in den Schaltungen 2a bzw. 2b und 3a bzw. 3b dargestellten Prüfimpulsen kann ein Auftreten mehrerer Fehler zu einer gegenseitigen Kompensation führen, wenn beispielsweise die Integrationskonstante k des Integrators 12 absinkt, gleichzeitig aber auch der Schwellwert S2 sich nach unten verschiebt, ist dieser Fehler nicht erkennbar. Genauso ist ein Verschieben des Schwellwertes S1 kompensierbar durch eine Verschiebung des Schwellwertes S2.

Wird jedoch das in Fig. 4a und 4b dargestellte Verfahren unter Beobachtung des Integratorausgangsignales verwendet, kann die Schwelle S2 explizit bestimmt werden. Dadurch ist eine Kompensation der Abweichungen der beiden anderen Parameter nicht mehr möglich, die verschiedenen Parameter können somit unabhängig voneinander erfaßt werden.

## Patentansprüche

1. Verfahren zum Prüfen der Auslöseschaltung für ein Airbag-System, mit einem Beschleunigungsaufnehmer, einem ersten Schwellwertschalter mit einem Schwellwert S1, der das vom Beschleunigungsaufnehmer abgegebene Signal nur bei Überschreiten des Schwellwertes passieren läßt, einem Integrator, der das vom ersten Schwellwertschalter abgegebene Signal aufintegriert, einem zweiten Schwellwertschalter mit einem Schwellwert S2, der eine Auslöseeinrichtung für das Airbag-System ansteuert, wenn der von dem Integrator abgegebene Wert den Schwellwert S2 überschreitet, und einer Prüfeinrichtung, die nach Auftrennen der Verbindung zwischen dem zweiten Schwellwertschalter und der Auslöseeinrichtung Impulse abgibt, *dadurch gekennzeichnet*, daß die Prüfeinrichtung einen Impuls mit vorgegebenem zeitlichen Amplitudenverlauf an den ersten Schwellwertschalter abgibt, wobei die Amplitude über zumindest einen Teil ihres zeitlichen Verlaufes den Wert S1 überschreitet und dieser Wert des zeitlichen Verlaufes ausreichend lang ist, um bei fehlerfreier Auslöseschaltung ein Überschreiten der Schwelle S2 zu einem vorbestimmten Zeitpunkt durch das von dem Integrator abgegebene Signal zu gewährleisten.

2. Verfahren nach Anspruch 1, *dadurch gekennzeichnet*, daß der Impuls eine konstante Amplitude besitzt, die größer als S1 ist.

3. Verfahren nach Anspruch 1, *dadurch gekennzeichnet*, daß für einen Zeitraum t1 die Amplitude kleiner als S1 ist und für einen Zeitraum t2 die Amplitude größer als S2 ist.

4. Verfahren nach Anspruch 3, *dadurch gekennzeichnet*, daß der Impuls ein Sägezahn ist.

5. Verfahren nach Anspruch 3 oder 4, *dadurch gekennzeichnet*, daß man zur Bestimmung des zweiten Schwellwertes S2 den zeitlichen Verlauf des Integratorausgangswertes erfaßt.

6. Verfahren nach einem der vorhergehenden Ansprüche, *dadurch gekennzeichnet*, daß aus dem die Schwelle S1 übersteigenden Amplitudenverlauf der Zeitpunkt vorherbestimmt wird, zu dem das Integratorausgangssignal den Auslösewert S2 erreicht.

7. Verfahren nach Anspruch 6, *dadurch gekennzeichnet*, daß bei Ausbleiben des Auslösesignals zum vorherbestimmten Zeitpunkt ein Fehlersignal abgegeben wird.

## Claims

1. Method for testing the trip circuit for an airbag system, with an acceleration sensor, a first threshold value switch having a threshold value S1 and allowing the signal emitted by the acceleration sensor to pass only when the threshold value is exceeded, an integrator which integrates-up the signal emitted by the first threshold value switch, a second threshold value switch having a threshold value S2 and actuating a trip device for the airbag system when the value emitted by the integrator exceeds the threshold value S2, and a test device which emits pulses after the connection between the second threshold value switch and the trip device has been disconnected, characterised in that the test device delivers to the first threshold value switch a pulse having a predetermined amplitude characteristic over time, the amplitude exceeding the value S1 over at least part of the time characteristic of the said amplitude, and this time characteristic value is sufficiently long to ensure that if the trip circuit is free of faults the threshold S2 is exceeded at a specific point in time by the signal emitted by the integrator.

2. Method according to claim 1, characterised in that the pulse has a constant amplitude which is greater than S1.

3. Method according to claim 1, characterised in that for a period of time t1 the amplitude is lower than S1, and for a period of time t2 the amplitude is greater than S2.

4. Method according to claim 3, characterised in that the pulse is a sawtooth pulse.

5. Method according to claim 3 or 4, characterised in that the time characteristic of the integrator output value is ascertained to determine the second threshold value S2.

6. Method according to one of the foregoing claims, characterised in that the point in time at which the integrator output signal reaches the trip value S2 is predetermined from the amplitude characteristic exceeding the threshold S1.

7. Method according to claim 6, characterised in that a fault signal is emitted if the trip signal fails to occur at the pre-determined point in time.

**Revendications**

1. Procédé d'essai du circuit de déclenchement d'un système de coussin pneumatique de sécurité comprenant un capteur d'accélération (10), un premier commutateur à seuil ayant une valeur seuil S1, qui ne laisse passer le signal délivré par le capteur d'accélération qu'en cas de dépassement de la valeur seuil, un intégrateur (12) qui intègre le signal délivré par le premier commutateur à seuil, un second commutateur à seuil (20) ayant une valeur seuil S2, qui commande un dispositif de déclenchement pour le système de coussin pneumatique de sécurité lorsque la valeur fournie par l'intégrateur dépasse la valeur seuil S2, et un dispositif d'essai qui délivre des impulsions après la suppression de la connexion entre le second commutateur à seuil et le dispositif de déclenchement, caractérisé en ce que le dispositif d'essai délivre au premier commutateur à seuil une impulsion ayant une variation prédéterminée de son amplitude en fonction du temps, cette amplitude dépassant la valeur S1 dans une partie au moins de sa variation dans le temps et cette valeur de la variation dans le temps étant suffisamment longue pour garantir que quand le circuit de déclenchement est exempt de défauts, le seuil S2 sera dépassé par le signal délivré par l'intégrateur à un instant prédéterminé.

2. Procédé selon la revendication 1, caractérisé en ce que l'impulsion a une amplitude constante qui est supérieure à S1.

3. Procédé selon la revendication 1, caractérisé en ce que pendant un laps de temps t1, l'amplitude est inférieure à S1 et pendant un laps de temps t2, l'amplitude est supérieure à S2.

4. Procédé selon la revendication 3, caractérisé en ce que l'impulsion est une dent de scie.

5. Procédé selon la revendication 3 ou 4, caractérisé en ce qu'on enregistre la variation dans le temps de la valeur de sortie de l' intégrateur pour la détermination de la seconde valeur seuil S2.

6. Procédé selon l'une quelconque des revendications 1 à 5, caractérisé en ce que l'instant auquel le signal de sortie de l'intégrateur atteint la valeur de déclenchement S2 est déterminé au préalable à partir de la variation d'amplitude dépassant le seuil S1.

7. Procédé selon la revendication 6, caractérisé en ce qu'un signal d'erreur est produit en cas d'absence du signal de déclenchement à l'instant déterminé au préalable.

FIG.1

FIG.2a

FIG.2b

FIG.3a

FIG.3b

FIG.4a

FIG.4b